# EUROPEAN PATENT APPLICATION

(11) **EP 4 596 522 A1**
(43) Date of publication of application: **06.08.2025**
(21) Application number: 23871862.1
(22) Date of filing: 11.09.2023
(51) Int. Cl.: C04B 35/495, H10N 30/067, H10N 30/50, H10N 30/853

(54) **LEAD-FREE PIEZOELECTRIC COMPOSITION, AND PIEZOELECTRIC ELEMENT**

(30) Priority: 30.09.2022 JP 2022158309
(71) Applicant: Niterra Co., Ltd., Nagoya-shi, Aichi 461-0005 (JP)
(72) Inventor: HIROSE, Yoshinobu, Nagoya-shi, Aichi 461-0005 (JP); ICHIHASHI, Kentaro, Nagoya-shi, Aichi 461-0005 (JP); NISHI, Tomohiro, Nagoya-shi, Aichi 461-0005 (JP); YAMAZAKI, Masato, Nagoya-shi, Aichi 461-0005 (JP)
(74) Representative: Grünecker Patent- und Rechtsanwälte PartG mbB
(86) International application number: PCT/JP2023/033008
(87) International publication number: WO 2024/070626

(57) **Abstract**

A lead-free piezoelectric composition according to the present invention has an alkali-niobate-based perovskite oxide containing Mn, Ti, and Sc as a main component, the content ratio of Sc to Ti being 0.004-8.

## Description

### TECHNICAL FIELD

The present invention relates to a lead-free piezoelectric composition and to a piezoelectric element.

### BACKGROUND ART

Hitherto, many piezoelectric elements have been formed of a PZT (lead zirconate titanate) material. However, a lead component contained in PZT evokes a problematic impact on the environment. Thus, in recent years, development of piezoelectric elements formed of a lead-free material has been pursued. For example, an alkali niobate perovskite-type oxide has been proposed as the lead-free material.

In recent years, a piezoelectric element used in a laminate-type actuator or the like must have high field actuating performance and high reliability. Such a piezoelectric element includes inner electrodes and piezoelectric ceramic layers formed of a lead-free alkali niobate perovskite-type oxide, the two members being alternatingly stacked (see, for example, Patent Literature 1). When voltage is applied to the piezoelectric element, the piezoelectric ceramic undergoes expansion and contraction in response to the applied voltage. Thus, the piezoelectric element exhibits suitable piezoelectric characteristics under high electric field.

### CITATION LIST

### PATENT LITERATURE

Patent Literature 1: JP 3945536B

### (Problems to be Solved by the Invention)

Although the lead-free piezoelectric composition for use in the aforementioned piezoelectric device is excellent in piezoelectric characteristics under high electric field, the insulation property is unsatisfactory at high temperature.

### SUMMARY OF INVENTION

An object of the present invention is to provide a lead-free piezoelectric composition which is excellent in piezoelectric characteristics and insulation property at high temperature, and the like.

### (Means for Solving the Problems)

The means for solving the aforementioned problem is as follows. Specifically,
<1> A lead-free piezoelectric composition which contains, as a main component, an alkali niobate perovskite-type oxide containing Mn, Ti, and Sc, which composition has a ratio of Sc content to Ti content of 0.004 or more and 8 or less.
<2> A lead-free piezoelectric composition according to <1> above, in which the alkali niobate perovskite-type oxide is represented by the following compositional formula (1):

   (A1ₐM1_{b})_{c}(Nb_{d1}Mn_{d2}Ti_{d3}Zr_{d4}Sc_{d5})O₃₊ₑ ··· (1)

   (in which element A1 represents at least one species of Li, Na, and K; element M1 represents at least one species of Ba, Ca, and Sr; conditions: 0<a<1, 0<b<1, a+b=1, 0.80<c<1.10, 0<d1<1, 0<d2<1, 0<d3<1, 0≤d4<1, 0<d5<1, and d1+d2+d3+d4+d5=1 are satisfied; and e is any value ensuring establishment of the perovskite-type crystal structure structure).
<3> A lead-free piezoelectric composition according to <2> above, in which the element M1 includes Ba, and conditions: 0.06≤b≤0.20 and 0.06≤d4≤0.20 are satisfied.
<4> A lead-free piezoelectric composition according to <1> or <2> above, in which crystal grains of the alkali niobate perovskite-type oxide have a mean grain size of 1.2 µm or more and 8.1 µm or less.
<5> A piezoelectric element having a structure in which a lead-free piezoelectric composition as recited in any one of <1> to <4> above and an electrode are alternatingly stacked.

### (Advantageous Effects of the Invention)

According to the present invention, a lead-free piezoelectric composition which is excellent in piezoelectric characteristics and insulation property at high temperature, and the like can be provided.

### BRIEF DESCRIPTION OF DRAWINGS

[FIG. 1] Perspective view of a piezoelectric element of embodiment 1.
[FIG. 2] Cross-section of a piezoelectric element of embodiment 2.

### DESCRIPTION OF EMBODIMENTS

Hereinafter, the lead-free piezoelectric composition and the piezoelectric element according to an embodiment will be described.

The lead-free piezoelectric composition contains, as a main component, an alkali niobate perovskite-type oxide containing Mn (manganese), Ti (titanium), and Sc (scandium). That is, the lead-free piezoelectric composition contains the alkali niobate perovskite-type oxide as a primary phase.

The alkali niobate perovskite-type oxide is represented by the following compositional formula (1).

(A1ₐM1_{b})_{c}(Nb_{d1}Mn_{d2}Ti_{d3}Zr_{d4}Sc_{d5})O₃₊ₑ ··· (1)

The element A1 is an alkali metal which is at least one species of Li (lithium), Na (sodium), and K (potassium). The element M1 is an alkaline earth metal which is at least one species of Ba (barium), Ca (calcium), and Sr (strontium).

In the above compositional formula (1), the element A1 and the element M1 are disposed in A sites of the perovskite structure, and Nb (niobium), Mn (manganese), Ti (titanium), and Zr (zirconium) are disposed in B sites.

In the compositional formula (1), coefficients a to e are selected from the values which are preferred from the viewpoints of electrical characteristics and piezoelectric characteristics and the like of the lead-free piezoelectric composition.

Specifically, coefficients a and b satisfy the conditions: 0<a<1, 0<b<1, and a+b=1. However, the cases of a=0 (i.e., the composition containing no alkali metal) and b=0 (i.e., the composition containing none of Ca, Sr, and Ba) are excluded.

Coefficient c with respect to the entire A sites satisfies 0.80<c<1.10, and is preferably 0. 90≤c≤1.05.

Coefficients d1, d2, d3, d4, and d5 satisfy the conditions: 0<d1<1, 0<d2<1, 0<d3<1, 0≤d4<1, 0<d5<1 and d1+d2+d3+d4+d5=1. However, the cases of d1=0 (i.e., the composition containing no Nb), d2=0 (i.e., the composition containing no Mn), and d3=0 (i.e., the composition containing no Ti), and d5=0 (i.e., the composition containing no Sc) are excluded. Coefficient d4 to Zr may be 0 (i.e., any composition containing no Zr being acceptable).

Meanwhile, coefficient d1 to Nb preferably satisfies 0.745≤d1≤0.950, more preferably 0.830≤d1≤0.959. Coefficient d2 to Mn preferably satisfies 0.001≤d2≤0.07. Coefficient d3 to Ti preferably satisfies 0.005≤d3≤0.06. Coefficient d4 to Zr preferably satisfies 0≤d4≤0.2, more preferably 0≤d4≤0.1. Coefficient d5 to Sc preferably satisfies 0.0002≤d5≤0.05.

In coefficient (3+e) with respect to oxygen, the value of e is a positive or negative value showing deficiency or excess from the intrinsic value of 3 with respect to oxygen. Coefficient (3+e) with respect to oxygen may be a value which allows the primary phase to have a perovskite oxide structure. Typically, coefficient e is 0, and preferably satisfies 0≤e≤0.1. Notably, coefficient e may also be calculated from the composition of the primary phase to meet the electrically neutral condition. However, needless to say, a composition of the primary phase which is slightly deviated from the electrically neutral condition is also allowable.

In the aforementioned compositional formula (1), preferably, the element M1 includes Ba, and conditions: 0.06≤b≤0.20 and 0.06≤d4≤0.20 are satisfied. When the aforementioned compositional formula (1) satisfies such conditions, excellent properties, in particular piezoelectric characteristics (displacement characteristics), can be attained. In this case, preferably, the above conditions further include 0.80≤a≤0.94, a+b=1, 0.80<c<1.10 (preferably 0.90≤c≤1.05), 0.745≤d1≤0.885, 0.01≤d2≤0.07, 0.005≤d3≤0.06, 0.06≤d4≤0.2, 0.001≤d5≤0.04, d1+d2+d3+d4+d5=1, and 0≤e≤0.1.

Among the alkali niobate perovskite-type oxides represented by the aforementioned compositional formula (1), those containing K, Na, and Nb as main metallic components are called "KNN" or "KNN material" and exhibit excellent properties such as piezoelectric and electric characteristics.

Notably, the aforementioned compositional formula (1) can be transformed into the following compositional formula (1A).

(Kₐ₁Naₐ₂Liₐ₃Ba_{b1}Ca_{b2}Sr_{b3})_{c}(Nb_{d1}Mn_{d2}Ti_{d3}Zr_{d4}Sc_{d5})O₃₊ₑ ··· (1A)

The aforementioned compositional formula (1) is equivalent to the above formula (1A), and the conditions: a1+a2+a3=a and b1+b2+b3=b are satisfied. Coefficient a1 with respect to K satisfies the condition: 0<a1≤0.7 (preferably 0.095≤a1≤0.665). Coefficient a2 with respect to Na satisfies the condition: 0<a1≤0.9 (preferably 0.285≤a2≤0.855). Coefficient a3 with respect to Li is 0≤a3≤0.2 (preferably 0≤a3≤0.1). Coefficient b1 with respect to Ba satisfies the condition: 0≤b1≤0.05. Coefficient b2 with respect to Ca satisfies the condition: 0≤b2≤0.05. Coefficient b3 with respect to Sr satisfies the condition: 0≤b3≤0.05.

In the alkali niobate perovskite-type oxide represented by the aforementioned compositional formula (1) or compositional formula (1A), the ratio of Sc content to Ti content (Sc/Ti) by mole is 0.004 or more and 8 or less. When the ratio of Sc content to Ti content falls within the range, a lead-free piezoelectric composition which is excellent in piezoelectric characteristics and insulation property at high temperature can be provided.

In the aforementioned compositional formula (1A), conditions 0.06≤b1≤0.20 and 0.06≤d4≤0.20 are preferably satisfied. When the aforementioned compositional formula (1A) satisfies the conditions, excellent properties, in particular piezoelectric characteristics (displacement characteristics), can be attained. In this case, preferably, the above conditions further include 0.400≤a1≤0.470, 0.400≤a2≤0.470, 0≤b2≤0.02, b3=0, a1+a2+b1+b2+b3=1, 0.80<c<1.10 (preferably 0.90≤c≤1.05), 0.745≤d1≤0.885, 0.01≤d2≤0.07, 0.005≤d3≤0.06, 0.06≤d4≤0.2, 0.001≤d5≤0.04, d1+d2+d3+d4+d5=1, and 0≤e≤0.1.

In the present embodiment, no particular limitation is imposed on the relative amount of the primary phase contained in the lead-free piezoelectric composition, so long as the object of the present invention is not impaired. However, the primary phase content is preferably, for example, 50 vol.% or more, more preferably 70 vol.% or more, still more preferably 90 vol.% or more.

So long as the object of the present invention is not impaired, the lead-free piezoelectric composition of the present embodiment may include a secondary phase formed of an additional crystalline phase other than the crystalline phase of the aforementioned alkali niobate perovskite-type oxide.

In the lead-free piezoelectric composition of the present embodiment, the mean grain size of the alkali niobate perovskite-type oxide crystal grains forming the primary phase is preferably 1.2 µm or greater and 8.1 µm or smaller. When the mean grain size falls within the range, particularly, an excellent insulation property at high temperature (e.g., 150°C) can be attained. The mean grain size is determined through the method mentioned below.

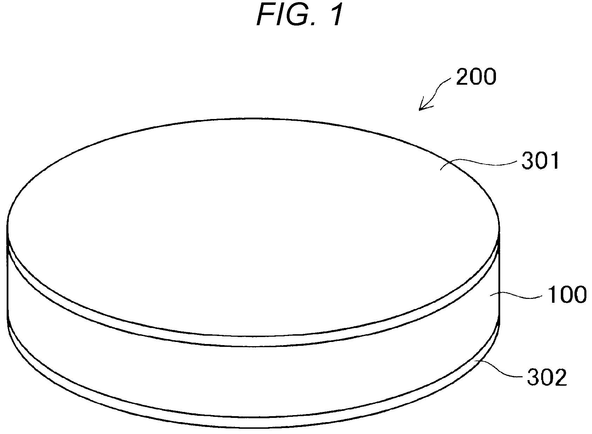

Next, a piezoelectric element 200 according to embodiment 1 will be described, with reference to FIG. 1. FIG. 1 is a perspective view of a piezoelectric element 200 of embodiment 1. As shown in FIG. 1, the piezoelectric element 200 of the present embodiment has a disk shape in appearance, and includes a disk-shape piezoelectric layer (an example of the piezoelectric ceramic layer) 100, an electrode 301 disposed on one surface of the piezoelectric layer 100, and an electrode 302 disposed on the other surface. The piezoelectric layer 100 is formed from the aforementioned lead-free piezoelectric composition. The piezoelectric layer 100 is polarized toward the thickness direction. The electrodes 301, 302 are formed of, for example, Au.

An example of the method of producing the aforementioned piezoelectric element 200 according to embodiment 1 will next be described. First, a plurality of essential ingredients for producing a primary phase are chosen from powder-form raw materials, and weighed so as to attain a target composition. The powder-form raw materials may be an oxide, a carbonate salt, a hydroxide, or the like of an element forming the primary phase. To the thus-weighed powder raw materials, ethanol is added, and the mixture is subjected to wet mixing by means of a ball mill preferably for 15 hours or longer, to thereby yield a slurry. The thus-obtained slurry was dried to form a powder mixture, and the powder is calcined under the conditions, for example, 600 to 1,000°C in air for 1 to 10 hours, to thereby obtain a powder-form primary phase calcined product.

Subsequently, the thus-obtained primary phase calcined product is mixed with a dispersant, a binder and ethanol, and the mixture is pulverized and mixed, to thereby give a slurry. The thus-obtained slurry is dried, and the product is suitably granulated and monoaxially pressed at a pressure, for example, 20 MPa, to thereby provide a preliminary compact of a disk shape. The thus-obtained preliminary compact is subjected to a cold isostatic pressing (CIP) treatment at, for example, 150 MPa, to thereby yield a compact.

Then, the thus-obtained compact is maintained at, for example, 200 to 400°C for 2 to 10 hours, to thereby effect debinding. The thus-debindered compact is fired at, for example, 1,000 to 1,200°C in a pressure-controlled reducing atmosphere (a pressure controlled to a reduction side from Ni/NO equilibrium oxygen partial pressure by order of 1 or greater) for 2 to 5 hours, to thereby form a piezoelectric layer.

On each surface of the formed piezoelectric layer, an Au electrode is formed through, for example, sputtering. Subsequently, the stacked body having the piezoelectric layer equipped with the electrodes is placed in silicone oil at 50°C and subjected to polarization treatment by applying a DC voltage of 5 kv/mm, to thereby generate a voltage characteristic of the piezoelectric layer. Thus, the piezoelectric element 200 is yielded.

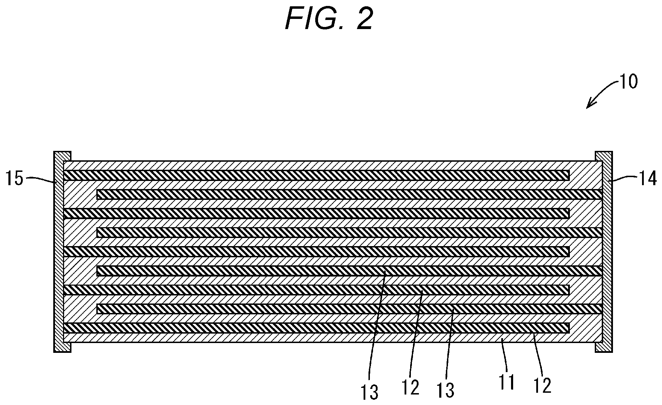

With reference to FIG. 2, a piezoelectric element 10 according to embodiment 2 will next be described in detail. FIG. 2 is a cross-section of the piezoelectric element 10 according to embodiment 2. As shown in FIG. 2, the piezoelectric element 10 of the present embodiment has a piezoelectric layer (an example of the voltage ceramic layer) 11, a plurality of inner electrodes 12, 13 which are in contact with the piezoelectric layer 11, and two outer electrodes 14, 15 which are connected to the inner electrodes 12, 13. The piezoelectric layer 11 is formed of the aforementioned lead-free piezoelectric composition. The inner electrodes 12, 13 are predominantly formed of a base metal (e.g., nickel). The piezoelectric layer 11 and the inner electrodes 12, 13 are alternatingly stacked. More specifically, the piezoelectric layer 11 and the inner electrodes 12, 13 are stacked , for example, in an order of the piezoelectric layer 11, the inner electrode 12, the piezoelectric layer 11, the inner electrode 13, and the piezoelectric layer 11. One piezoelectric layer 11 is sandwiched by two inner electrodes 12, 13. The two outer electrodes 14, 15 are disposed on the outer surface of the stacked body of the piezoelectric layer 11 and the inner electrodes 12, 13. The outer electrodes 14, 15 are predominantly formed of, for example, Au. Among the two inner electrodes 12, 13 in contact with the one piezoelectric layer 11, an end of the inner electrode 12 is connected to the outer electrode 14, and an end of the inner electrode 13 is connected to the outer electrode 15. Through application of a voltage between the outer electrodes 14, 15, the piezoelectric layer 11 expands and contract, whereby the piezoelectric element 10 in entirety expands and contracts.

An example of the method of producing the piezoelectric element 10 according to embodiment 2 will next be described. First, a plurality of essential ingredients for producing a primary phase are chosen from powder-form raw materials, and weighed so as to attain a target composition. The powder-form raw materials may be an oxide, a carbonate salt, a hydroxide, or the like of an element forming the primary phase. To the thus-weighed powder raw materials, ethanol is added, and the mixture is subjected to wet mixing by means of a ball mill preferably for 15 hours or longer, to thereby yield a slurry. The slurry was dried to form a powder mixture, and the powder is calcined under the conditions, for example, 600 to 1,000°C in air for 1 to 10 hours, to thereby obtain a powder-form primary phase calcined product.

Subsequently, the thus-obtained primary phase calcined product is mixed with a dispersant, a binder, and an organic solvent (e.g., toluene), and the mixture is pulverized and mixed, to thereby give a slurry. Then, the thus-obtained slurry is formed into a sheet through a doctor blade method or the like, to thereby produce a ceramic green sheet.

Then, an electrode layer serving as an inner electrode is formed on a surface of the ceramic green sheet by use of a conductive paste for forming an inner electrode through, for example, screen printing. The electrode layer is predominantly formed of a base metal (e.g., nickel (Ni)).

Next, a plurality of ceramic green sheets each provided with an electrode layer are stacked such that the electrode layers are exposed in an alternating manner, and ceramic green sheets each provided with no electrode layer are stacked on each surface of the stacked body. The thus-obtained stacked bodies are press-bonded, to thereby yield a stacked body in which ceramic green sheets and electrode layers have been alternatingly stacked. The resultant stacked body is cut into a shape of interest, and then maintained at a temperature, for example, 200 to 400°C for 2 to 10 hours, to thereby perform debindering.

Next, the debindered stacked body is maintained for firing at a temperature, for example, 1,000 to 1,200°C in a pressure-controlled reducing atmosphere (a pressure controlled to a reduction side from Ni/NO equilibrium oxygen partial pressure by order of 1 or greater) for 2 to 5 hours.

A side surface of the thus-fired stacked body is appropriately polished, and a pair of outer electrodes formed of Au are formed on the side surface of the stacked body through sputtering or a similar technique. The pair of outer electrodes are formed such that they sandwich the stacked body and oppositely face each other. The stacked body equipped with the outer electrodes is subjected to a polarization treatment, to thereby yield the piezoelectric element 10. Thus, a piezoelectric element (a stacked-type piezoelectric element) 10 having a structure in which piezoelectric layers formed of a lead-free piezoelectric composition and electrodes (inner electrodes) are alternatingly stacked is yielded.

The production methods of embodiments 1 and 2 as described above are a merely an exemplary method, and various other steps and treatment conditions for producing a piezoelectric element may be employed. In an alternative method, when the lead-free piezoelectric composition includes a secondary phase, a plurality of raw material powders required to form the secondary phase are provide, and the raw material may be appropriately formed into a powder-form calcined product for the secondary phase. The thus-obtained secondary phase calcined product may be appropriately mixed with the primary phase calcined product at a specific ratio, to thereby fabricate a piezoelectric element of interest. Also, the material used for forming the electrode may be a metal or an alloy such as platinum (Pt), silver-palladium (Ag-Pd), or silver (Ag).

The lead-free piezoelectric composition and the piezoelectric element disclosed in the present specification exhibit excellent piezoelectric characteristic at high electric field and excellent insulation property at high temperature (e.g., 150°C). Such a lead-free piezoelectric composition and a piezoelectric element find various uses including vibration sensing, pressure sensing, oscillation, and piezoelectric devices. Examples of the possible use include sensors for detecting various vibrations (e.g., a knocking sensor and a combustion pressure sensor); piezoelectric devices such as an oscillator, an actuator, and a filter; high-voltage generators; micro power supplies; driving units; position control systems; vibration dampers; and fluid discharge systems (e.g., a paint ejector and a fuel ejector).

### EXAMPLES

The present invention will next be described in detail by way of example, which should not be construed as limiting the invention thereto.

### [Examples 1 to 48 and Comparative Examples 1 to 8]

### (Preparation of primary phase calcined product)

K₂CO₃ powder, Na₂CO₃ powder, Nb₂O₅ powder, TiO₂ powder, ZrO₂ powder, MnCO₃ powder, BaCO₃ powder, and Sc₂O₃ powder were provided as raw material powders. These powders were weighed so as to produce composition shown in Tables 1 to 4. To a mixture of the thus-weighed raw material powders, an appropriate amount of ethanol was added, and the resultant mixture was wet-mixed by means of a ball mill for 15 hours, to thereby prepare a slurry. The slurry was dried to provide a powder-form mixture, and the mixture was calcined in air at 600 to 1,100°C for 1 to 10 hours, to thereby yield a powder-form primary phase calcined product.

### (Fabrication of piezoelectric element)

The thus-obtained primary phase calcined product was mixed with a dispersant, a binder and ethanol, and the mixture was pulverized and mixed, to thereby give a slurry. The thus-obtained slurry was dried, and the product was suitably granulated and monoaxially pressed at 20 MPa, to thereby provide a preliminary compact of a disk shape. The thus-obtained preliminary compact was subjected to a cold isostatic pressing (CIP) treatment at a pressure of 150 MPa, to thereby yield a compact.

The thus-obtained compact was maintained at 200 to 400°C for 2 to 10 hours, to thereby effect debindering. The thus-debindered compact was fired at 1,000 to 1,200°C in a pressure-controlled reducing atmosphere (a pressure controlled to a reduction side from Ni/NO equilibrium oxygen partial pressure by order of 1 or greater) for 2 to 5 hours, to thereby form a piezoelectric layer.

On each surface of the formed piezoelectric layer, an Au electrode was formed through sputtering. Subsequently, the stacked body having the piezoelectric layer equipped with the electrodes was placed in silicone oil at 50°C and subjected to polarization treatment by applying a DC voltage of 5 kV/mm, to thereby generate a voltage characteristic of the piezoelectric layer. Thus, a piezoelectric element was fabricated.

### [Assessment of piezoelectric characteristics]

To a piezoelectric element (a piezoelectric layer) of each of the Examples and Comparative Examples, an electric field of 1 to 10 kV/mm was applied by means of a laser Doppler vibroemeter. A displacement S of the element in the vertical direction was measured at a measurement frequency of 100 Hz. The displacement S was divided by electric field E to calculate an S/E ratio at each electric field value. The S/E value at the maximum (Smax/Emax) was employed to assess a displacement characteristic (piezoelectric characteristic). Tables 1 to 4 show the results.

### [Measurement of insulation resistance]

Insulation resistance (Ω·m) of a voltage element of each of the Examples and Comparative Examples was measured through the following procedure. Specifically, the piezoelectric element was placed in silicon oil at 150°C, and a DC voltage was applied to the element in silicon oil at 5 kV/mm for 1 minute. The insulation resistance (Ω·m) after application of the voltage was measured. Tables 1 to 4 show the results.

### [Analysis of primary phase]

A voltage element (a piezoelectric layer) of each of the Examples and Comparative Examples was subjected to a compositional analysis of the primary phase through the following procedure by means of a scanning electron microscope-energy dispersive X-ray spectrometer (SEM-EDS). Specifically, the piezoelectric layer of the piezoelectric element was cut along the thickness direction, and the cut surface was polished. A photoimage of the polished surface was taken by an SEM at a magnification of 3,000. In the obtained photoimage, three crystal grains in the primary phase were selected at random, and the three crystal grains were subjected to element quantitation by means of an EDS. In the quantitation, the measurement probe diameter of electron beam was adjusted to about 1 µm. The thus-obtained element contents of the three crystal grains were averaged, to thereby determine the compositional proportions of the primary phase of each of the Examples and Comparative Examples Tables 1 to 4 show the results. Notably, the symbol "-" in Tables 1 to 4 denotes a value lower than the detection limit of the apparatus.

### [Mean crystal grain sizes of crystal grains of primary phase]

The aforementioned polished surface of the voltage element (the piezoelectric layer) of each of Examples 12 and 45 to 48 and Comparative Examples 6 to 8 was observed under a scanning electron microscope (SEM) at a magnification of 3,000, and an image was taken. In the obtained SEM image (i.e., reflected electron image), a square (250 µm × 250 µm) for measurement was placed. A plurality of crystal grains present in the measurement square were analyzed by image analysis software, to thereby determine a long-axis diameter and a short-axis diameter. In one crystal grain, the long-axis diameter and the short-axis diameter cross at right angle. The values of long-axis diameter and short-axis diameter are the maximum values along the corresponding axis. The average value of the long-axis diameter and short-axis diameter of the crystal grain was employed as a grain size of each crystal grain. The thus-obtained average grain size of the crystal grain falling within the aforementioned measurement range was employed as a mean grain size (µm) of crystal grains of the primary phase.

**Table 1**

| Element | A1 | | M1 | | | | Nb | Mn | Ti | Zr | Sc |
|---|---|---|---|---|---|---|---|---|---|---|---|
| | K | Na | Ba | Ca | Sr | | | | | | |
| Coefficient | a | | b | | | c | d | | | | |
| | a1 | a2 | b1 | b2 | b3 | | d1 | d2 | d3 | d4 | d5 |
| Comp. Ex. 1 | 0.475 | 0.475 | 0.05 | - | - | 1.00 | 0.920 | 0.02 | - | 0.05 | 0.01 |
| Comp. Ex. 2 | 0.475 | 0.475 | 0.05 | - | - | 1.00 | 0.910 | 0.02 | 0.02 | 0.05 | - |
| Comp. Ex. 3 | 0.475 | 0.475 | 0.05 | - | - | 1.00 | 0.920 | - | 0.02 | 0.05 | 0.01 |
| Ex. 1 | 0.475 | 0.475 | 0.05 | - | - | 1.00 | 0.924 | 0.02 | 0.005 | 0.05 | 0.001 |
| Ex. 2 | 0.475 | 0.475 | 0.05 | - | - | 1.00 | 0.915 | 0.02 | 0.005 | 0.05 | 0.01 |
| Ex. 3 | 0.475 | 0.475 | 0.05 | - | - | 1.00 | 0.885 | 0.02 | 0.005 | 0.05 | 0.04 |
| Comp. Ex. 4 | 0.475 | 0.475 | 0.05 | - | - | 1.00 | 0.875 | 0.02 | 0.005 | 0.05 | 0.05 |
| Ex. 4 | 0.475 | 0.475 | 0.05 | - | - | 1.00 | 0.920 | 0.02 | 0.01 | 0.05 | 0.0002 |
| Ex. 5 | 0.475 | 0.475 | 0.05 | - | - | 1.00 | 0.919 | 0.02 | 0.01 | 0.05 | 0.001 |
| Ex. 6 | 0.475 | 0.475 | 0.05 | - | - | 1.00 | 0.917 | 0.02 | 0.01 | 0.05 | 0.003 |
| Ex. 7 | 0.475 | 0.475 | 0.05 | - | - | 1.00 | 0.909 | 0.02 | 0.02 | 0.05 | 0.001 |
| Ex. 8 | 0.475 | 0.475 | 0.05 | - | - | 1.00 | 0.900 | 0.02 | 0.02 | 0.05 | 0.01 |
| Ex. 9 | 0.475 | 0.475 | 0.05 | - | - | 1.00 | 0.880 | 0.02 | 0.02 | 0.05 | 0.03 |
| Ex. 10 | 0.475 | 0.475 | 0.05 | - | - | 1.00 | 0.900 | 0.02 | 0.03 | 0.05 | 0.0005 |
| Ex. 11 | 0.475 | 0.475 | 0.05 | - | - | 1.00 | 0.899 | 0.02 | 0.03 | 0.05 | 0.001 |
| Ex. 12 | 0.475 | 0.475 | 0.05 | - | - | 1.00 | 0.895 | 0.02 | 0.03 | 0.05 | 0.005 |
| Ex. 13 | 0.475 | 0.475 | 0.05 | - | - | 1.00 | 0.890 | 0.02 | 0.03 | 0.05 | 0.01 |
| Ex. 14 | 0.475 | 0.475 | 0.05 | - | - | 1.00 | 0.870 | 0.02 | 0.03 | 0.05 | 0.03 |
| Ex. 15 | 0.475 | 0.475 | 0.05 | - | - | 1.00 | 0.850 | 0.02 | 0.03 | 0.05 | 0.05 |
| Ex. 16 | 0.475 | 0.475 | 0.05 | - | - | 1.00 | 0.885 | 0.02 | 0.04 | 0.05 | 0.005 |

**Table 1 (continued)**

| | Sc/Ti (d5/d3) | Smax/ Emax (pm/V) | Insulation resistance (Ω·m) |
|---|---|---|---|
| | | | |
| Comp. Ex. 1 | - | 98 | 3×10⁹ |
| Comp. Ex. 2 | 0 | unmeasurable | 2×10⁵ |
| Comp. Ex. 3 | 0.500 | unmeasurable | unmeasurable |
| Ex. 1 | 0.200 | 160 | 2×10⁹ |
| Ex. 2 | 2.000 | 145 | 3×10⁹ |
| Ex. 3 | 8.000 | 132 | 3×10⁹ |
| Comp. Ex. 4 | 10,000 | 104 | 3×10⁹ |
| Ex. 4 | 0.020 | 170 | 8×10⁸ |
| Ex. 5 | 0.100 | 180 | 2×10⁹ |
| Ex. 6 | 0.300 | 178 | 3×10⁹ |
| Ex. 7 | 0.050 | 190 | 3×10⁹ |
| Ex. 8 | 0.500 | 174 | 6×10⁹ |
| Ex. 9 | 1.500 | 168 | 3×10⁹ |
| Ex. 10 | 0.017 | 226 | 7×10⁸ |
| Ex. 11 | 0.033 | 230 | 1×10⁹ |
| Ex. 12 | 0.167 | 227 | 2×10⁹ |
| Ex. 13 | 0.333 | 222 | 3×10⁹ |
| Ex. 14 | 1.000 | 206 | 2×10⁹ |
| Ex. 15 | 1.667 | 196 | 3×10⁹ |
| Ex. 16 | 0.125 | 210 | 2×10⁹ |

**Table 2**

| Element | A1 | | M1 | | | | Nb | Mn | Ti | Zr | Sc |
|---|---|---|---|---|---|---|---|---|---|---|---|
| | K | Na | Ba | Ca | Sr | | | | | | |
| Coefficient | a | | b | | | c | d | | | | |
| | a1 | a2 | b1 | b2 | b3 | | d1 | d2 | d3 | d4 | d5 |
| Ex. 17 | 0.475 | 0.475 | 0.05 | - | - | 1.00 | 0.880 | 0.02 | 0.04 | 0.05 | 0.01 |
| Ex. 18 | 0.475 | 0.475 | 0.05 | - | - | 1.00 | 0.880 | 0.02 | 0.05 | 0.05 | 0.0002 |
| Ex. 19 | 0.475 | 0.475 | 0.05 | - | - | 1.00 | 0.875 | 0.02 | 0.05 | 0.05 | 0.005 |
| Ex. 20 | 0.475 | 0.475 | 0.05 | - | - | 1.00 | 0.870 | 0.02 | 0.05 | 0.05 | 0.01 |
| Ex. 21 | 0.475 | 0.475 | 0.05 | - | - | 1.00 | 0.830 | 0.02 | 0.05 | 0.05 | 0.05 |
| Comp. Ex. 5 | 0.475 | 0.475 | 0.05 | - | - | 1.00 | 0.870 | 0.02 | 0.06 | 0.05 | 0.0002 |
| Ex. 22 | 0.475 | 0.475 | 0.05 | - | - | 1.00 | 0.869 | 0.02 | 0.06 | 0.05 | 0.001 |
| Ex. 23 | 0.475 | 0.475 | 0.05 | - | - | 1.00 | 0.928 | 0.001 | 0.02 | 0.05 | 0.001 |
| Ex. 24 | 0.475 | 0.475 | 0.05 | - | - | 1.00 | 0.919 | 0.01 | 0.02 | 0.05 | 0.001 |
| Ex. 25 | 0.475 | 0.475 | 0.05 | - | - | 1.00 | 0.879 | 0.05 | 0.02 | 0.05 | 0.001 |
| Ex. 26 | 0.475 | 0.475 | 0.05 | - | - | 1.00 | 0.859 | 0.07 | 0.02 | 0.05 | 0.001 |
| Ex. 27 | 0.095 | 0.855 | 0.05 | - | - | 1.00 | 0.909 | 0.02 | 0.02 | 0.05 | 0.001 |
| Ex. 28 | 0.665 | 0.285 | 0.05 | - | - | 1.00 | 0.909 | 0.02 | 0.02 | 0.05 | 0.001 |
| Ex. 29 | 0.495 | 0.495 | 0.01 | - | - | 1.00 | 0.959 | 0.02 | 0.02 | - | 0.001 |
| Ex. 30 | 0.475 | 0.475 | - | 0.05 | - | 1.00 | 0.909 | 0.02 | 0.02 | 0.05 | 0.001 |
| Ex. 31 | 0.475 | 0.475 | - | - | 0.05 | 1.00 | 0.909 | 0.02 | 0.02 | 0.05 | 0.001 |
| Ex. 32 | 0.450 | 0.450 | 0.05 | 0.05 | - | 1.00 | 0.859 | 0.02 | 0.02 | 0.1 | 0.001 |
| Ex. 33 | 0.095 | 0.855 | 0.05 | - | - | 0.90 | 0.909 | 0.02 | 0.02 | 0.05 | 0.001 |
| Ex. 34 | 0.095 | 0.855 | 0.05 | - | - | 1.05 | 0.909 | 0.02 | 0.02 | 0.05 | 0.001 |

**Table 2 (continued)**

| | Sc/Ti (d5/d3) | Smax/ Emax (pm/V) | Insulation resistance (Ω·m) |
|---|---|---|---|
| | | | |
| Ex. 17 | 0.250 | 206 | 2×10⁹ |
| Ex. 18 | 0.004 | 148 | 4×10⁸ |
| Ex. 19 | 0.100 | 162 | 9×10⁸ |
| Ex. 20 | 0.200 | 154 | 2×10⁹ |
| Ex. 21 | 1.000 | 143 | 3×10⁹ |
| Comp. Ex. 5 | 0.003 | 106 | 8×10⁸ |
| Ex. 22 | 0.017 | 137 | 2×10⁹ |
| Ex. 23 | 0.050 | 186 | 1×10⁹ |
| Ex. 24 | 0.050 | 191 | 3×10⁹ |
| Ex. 25 | 0.050 | 186 | 3×10⁹ |
| Ex. 26 | 0.050 | 175 | 2×10⁹ |
| Ex. 27 | 0.050 | 146 | 2×10⁹ |
| Ex. 28 | 0.050 | 148 | 1×10⁹ |
| Ex. 29 | 0.050 | 138 | 3×10⁹ |
| Ex. 30 | 0.050 | 167 | 2×10⁹ |
| Ex. 31 | 0.050 | 146 | 2×10⁹ |
| Ex. 32 | 0.050 | 188 | 2×10⁹ |
| Ex. 33 | 0.050 | 142 | 3×10⁹ |
| Ex. 34 | 0.050 | 135 | 2×10⁹ |

**Table 3**

| Element | A1 | | M1 | | | | Nb | Mn | Ti | Zr | Sc |
|---|---|---|---|---|---|---|---|---|---|---|---|
| | K | Na | Ba | Ca | Sr | | | | | | |
| Coefficient | a | | b | | | c | d | | | | |
| | a1 | a2 | b1 | b2 | b3 | | d1 | d2 | d3 | d4 | d5 |
| Ex. 35 | 0.470 | 0.470 | 0.06 | - | - | 1.00 | 0.885 | 0.02 | 0.03 | 0.06 | 0.005 |
| Ex. 36 | 0.460 | 0.460 | 0.08 | - | - | 1.00 | 0.865 | 0.02 | 0.03 | 0.08 | 0.005 |
| Ex. 37 | 0.450 | 0.450 | 0.10 | - | - | 1.00 | 0.845 | 0.02 | 0.03 | 0.10 | 0.005 |
| Ex. 38 | 0.425 | 0.425 | 0.15 | - | - | 1.00 | 0.795 | 0.02 | 0.03 | 0.15 | 0.005 |
| Ex. 39 | 0.400 | 0.400 | 0.20 | - | - | 1.00 | 0.745 | 0.02 | 0.03 | 0.20 | 0.005 |
| Comp. 6 | 0.375 | 0.375 | 0.25 | - | - | 1.00 | 0.695 | 0.02 | 0.03 | 0.25 | 0.005 |
| Ex. 40 | 0.450 | 0.450 | 0.10 | - | - | 1.00 | 0.849 | 0.02 | 0.03 | 0.10 | 0.001 |
| Ex. 41 | 0.450 | 0.450 | 0.10 | - | - | 1.00 | 0.835 | 0.02 | 0.005 | 0.10 | 0.04 |
| Ex. 42 | 0.450 | 0.450 | 0.10 | - | - | 1.00 | 0.865 | 0.02 | 0.03 | 0.08 | 0.005 |
| Ex. 43 | 0.440 | 0.440 | 0.10 | 0.02 | - | 1.00 | 0.845 | 0.02 | 0.03 | 0.10 | 0.005 |

**Table 3 (continued)**

| | Sc/Ti (d5/d3) | Smax/ Emax (pm/V) | Insulation resistance (Ω·m) |
|---|---|---|---|
| | | | |
| Ex. 35 | 0.167 | 251 | 3×10⁹ |
| Ex. 36 | 0.167 | 273 | 3×10⁹ |
| Ex. 37 | 0.167 | 348 | 3×10⁹ |
| Ex. 38 | 0.167 | 327 | 4×10⁹ |
| Ex. 39 | 0.167 | 248 | 4×10⁹ |
| Comp. 6 | 0.167 | 91 | 2×10⁹ |
| Ex. 40 | 0.050 | 325 | 2×10⁹ |
| Ex. 41 | 8.000 | 313 | 3×10⁹ |
| Ex. 42 | 8.000 | 323 | 2×10⁹ |
| Ex. 43 | 0.167 | 338 | 2×10⁹ |

**Table 4**

| Element | A1 | | M1 | | | | Nb | Mn | Ti | Zr | Sc |
|---|---|---|---|---|---|---|---|---|---|---|---|
| | K | Na | Ba | Ca | Sr | | | | | | |
| Coefficient | a | | b | | | c | d | | | | |
| | a1 | a2 | b1 | b2 | b3 | | d1 | d2 | d3 | d4 | d5 |
| Comp. 7 | 0.475 | 0.475 | 0.05 | - | - | 1.00 | 0.87 | 0.02 | 0.06 | 0.05 | 0.0002 |
| Ex. 44 | 0.475 | 0.475 | 0.05 | - | - | 1.00 | 0.895 | 0.02 | 0.03 | 0.05 | 0.005 |
| Ex. 45 | 0.475 | 0.475 | 0.05 | - | - | 1.00 | 0.895 | 0.02 | 0.03 | 0.05 | 0.005 |
| Ex. 46 | 0.475 | 0.475 | 0.05 | - | - | 1.00 | 0.895 | 0.02 | 0.03 | 0.05 | 0.005 |
| Ex. 12 | 0.475 | 0.475 | 0.05 | - | - | 1.00 | 0.895 | 0.02 | 0.03 | 0.05 | 0.005 |
| Ex. 47 | 0.475 | 0.475 | 0.05 | - | - | 1.00 | 0.895 | 0.02 | 0.03 | 0.05 | 0.005 |
| Ex. 48 | 0.475 | 0.475 | 0.05 | - | - | 1.00 | 0.895 | 0.02 | 0.03 | 0.05 | 0.005 |
| Comp. 8 | 0.475 | 0.475 | 0.05 | - | - | 1.00 | 0.895 | 0.02 | 0.03 | 0.05 | 0.005 |

**Table 4 (continued)**

| | Sc/Ti (d5/d3) | Mean grain size (µm) | Smax/ Emax (pm/V) | Insulation resistance (Ω·m) | Firing temp. (°C) | Holding time (hrs) |
|---|---|---|---|---|---|---|
| | | | | | | |
| Comp. 7 | 0.003 | 4.3 | 101 | 2×10⁸ | 1,050 | 2 |
| Ex. 44 | 0.167 | 1.2 | 195 | 8×10⁹ | 1,020 | 1 |
| Ex. 45 | 0.167 | 1.8 | 197 | 6×10⁹ | 1,020 | 2 |
| Ex. 46 | 0.167 | 2.1 | 215 | 4×10⁹ | 1,030 | 2 |
| Ex. 12 | 0.167 | 4.5 | 227 | 2×10⁹ | 1,050 | 2 |
| Ex. 47 | 0.167 | 6.7 | 234 | 8×10⁸ | 1,050 | 5 |
| Ex. 48 | 0.167 | 8.1 | 186 | 6×10⁸ | 1,060 | 5 |
| Comp. 8 | 0.167 | 10.3 | 103 | 1×10⁷ | 1,080 | 5 |

As shown in Tables 1 and 2, the lead-free piezoelectric compositions employed in the piezoelectric elements of Examples 1 to 34 each contain, as a primary component (primary phase), an alkali niobate perovskite-type oxide containing Mn, Ti, and Sc, and have a ratio Sc content to Ti content by mole of 0.004 or more and 8 or less in the alkali niobate perovskite-type oxide. In Examples 1 to 34 mentioned above, an insulation resistance at high temperature (150°C) was 4×10⁸ Ω·m or higher, indicating an excellent insulation property at high temperature. The maximum S/E value (Smax/Emax) was 132 pm/V or greater in Examples 1 to 34. Thus, excellent piezoelectric characteristics (displacement characteristics) were confirmed in Examples 1 to 34.

The lead-free piezoelectric composition of Comparative Example 1 was formed of an alkali niobate perovskite-type oxide containing Mn and Sc, but no Ti. The piezoelectric element of Comparative Example 1 exhibited an excellent insulation property at high temperature, but the maximum S/E value (Smax/Emax) was 98 pm/V, which was problematic in piezoelectric characteristics.

The lead-free piezoelectric composition of Comparative Example 2 was formed of an alkali niobate perovskite-type oxide containing Mn and Ti, but no Sc. The piezoelectric element of Comparative Example 2 was problematic in insulation property at high temperature. In Comparative Example 2, measurement of insulation resistance was not completed. In addition, the piezoelectric element of Comparative Example 2 was problematic in piezoelectric characteristics.

The lead-free piezoelectric composition of Comparative Example 3 was formed of an alkali niobate perovskite-type oxide containing Ti and Sc, but no Mn. Since the lead-free piezoelectric composition of Comparative Example 3 did not contain Mn, sinterabilty and other properties were poor, and the insulation property at high temperature and piezoelectric characteristics were problematic. In Comparative Example 3, measurement of the S/E value and insulation resistance was not completed.

The lead-free piezoelectric composition of Comparative Example 4 had an excessively high ratio of Sc content to Ti content (Sc/Ti=10). Although the piezoelectric element of Comparative Example 4 exhibited an excellent insulation property at high temperature, the maximum S/E value (Smax/Emax) was 104 pm/V, which was problematic in piezoelectric characteristics.

The lead-free piezoelectric composition of Comparative Example 5 had an excessively low ratio of Sc content to Ti content (Sc/Ti=0.003). Although the piezoelectric element of Comparative Example 5 exhibited an excellent insulation property at high temperature, the maximum S/E value (Smax/Emax) was 106 pm/V, which was problematic in piezoelectric characteristics.

The presence of Ti in the lead-free piezoelectric composition results in excellent piezoelectric characteristics. However, when the Ti content is excessively high, insulation property decreases. Also, the presence of Sc in the lead-free piezoelectric composition results in high insulation property at high temperature. However, a large amount of Sc tends to reduce ferroelectricity (i.e., to reduce piezoelectric characteristics), and piezoelectric characteristics decrease when the Ti content is small. Meanwhile, when the Ti content is high, loss of ferroelectricity is inhibited. Thus, even when a large amount of Sc is contained, piezoelectric characteristics are not impaired. Therefore, in the case of a lead-free piezoelectric composition formed of an alkali niobate perovskite-type oxide, the ratio of Sc content to Ti content conceivably plays an important role in achieving both piezoelectric characteristics and insulation property at high temperature. Notably, the sinterability of the lead-free piezoelectric composition is enhanced by virtue of the presence of Mn, to thereby demonstrate piezoelectric characteristics.

As is clear from Table 3, the lead-free piezoelectric compositions employed in the piezoelectric elements of Examples 35 to 43 each contain, as a primary component (primary phase), an alkali niobate perovskite-type oxide containing Mn, Ti, and Sc, and have a ratio Sc content to Ti content by mole of 0.004 or more and 8 or less in the alkali niobate perovskite-type oxide. Particularly, in Examples 35 to 43, the alkali niobate perovskite-type oxide forming the primary phase of the lead-free piezoelectric composition contained Ba and Zr, and satisfied conditions of coefficients b and d4 of 0.06≤b≤0.20 and 0.06≤d4≤0.20 in the aforementioned compositional formula (1), and conditions of coefficient b1 and d4 of 0.06≤b≤0.20 and 0.06≤d4≤0.20 in the aforementioned compositional formula (1A). In Examples 35 to 43 mentioned above, the maximum S/E value (Smax/Emax) was 248 pm/V or greater, particularly exhibiting excellent piezoelectric characteristics (displacement characteristics).

In contrast, as shown in Table 3, in Comparative Example 6, the alkali niobate perovskite-type oxide forming the primary phase of the lead-free piezoelectric composition have a coefficient b in the aforementioned compositional formula (1) greater than that of Example 35 or the like, and a coefficient d4 in the aforementioned compositional formula (1) greater than that of Example 35 or the like. In Comparative Example 6 mentioned above, the maximum S/E value (Smax/Emax) was 91 pm/V, which was problematic in piezoelectric characteristics (displacement characteristics).

Also, as shown in Table 4, in Examples 12 and 44 to 48, the crystal grains of the alkali niobate perovskite-type oxide have a mean grain size of 1.2 µm or more and 8.1 µm or less. In Examples 12 and 44 to 48 mentioned above, particularly, an excellent insulation property at high temperature (150°C) was confirmed.

In contrast, as shown in Table 4, in Comparative Example 7, the mean grain size of the crystal grains is 4.3 µm, but the ratio of Sc content to Ti content by mole in the alkali niobate perovskite-type oxide is 0.003. In Comparative Example 7 mentioned above, the insulation resistance was low, which was problematic in insulation property. Also, in Comparative Example 8, the mean grain size of the crystal grains was excessively large. In Comparative Example 8 mentioned above, the insulation resistance was low, which was problematic in insulation property.

Notably, Table 4 shows production conditions (firing temperature (°C) and holding time (hrs)) employed in Examples 12, and 44 to 48, and Comparative Examples 7 and 8.

### REFERENCE SIGNS LIST

10, 200: piezoelectric element
11, 100: piezoelectric layer (piezoelectric ceramic layer)
12, 13: inner electrode
14, 15: outer electrode
301, 302: electrode

## Claims

1. A lead-free piezoelectric composition comprising, as a main component, an alkali niobate perovskite-type oxide containing Mn, Ti, and Sc, which composition has a ratio of Sc content to Ti content of 0.004 or more and 8 or less.

2. A lead-free piezoelectric composition according to claim 1, wherein the alkali niobate perovskite-type oxide is represented by the following compositional formula (1):
(A1ₐM1_{b})_{c}(Nb_{d1}Mn_{d2}Ti_{d3}Zr_{d4}Sc_{d5})O₃₊ₑ ··· (1)
(wherein element A1 represents at least one species of Li, Na, and K; element M1 represents at least one species of Ba, Ca, and Sr; conditions: 0<a<1, 0<b<1, a+b=1, 0.80<c<1.10, 0<d1<1, 0<d2<1, 0<d3<1, 0≤d4<1, 0<d5<1, and d1+d2+d3+d4+d5=1 are satisfied; and e is any value ensuring establishment of the perovskite-type crystal structure).

3. A lead-free piezoelectric composition according to claim 2, wherein the element M1 includes Ba, and conditions: 0.06≤b≤0.20 and 0.06≤d4≤0.20 are satisfied.

4. A lead-free piezoelectric composition according to claim 1 or 2, wherein crystal grains of the alkali niobate perovskite-type oxide have a mean grain size of 1.2 µm or more and 8.1 µm or less.

5. A piezoelectric element having a structure in which a lead-free piezoelectric composition as recited in any one of claims 1 to 4 and an electrode are alternatingly stacked.
